# EUROPÄISCHE PATENTSCHRIFT

(11) **EP 2 383 509 B1**
(45) Veröffentlichungstag und Bekanntmachung des Hinweises auf die Patenterteilung: **02.12.2015**
(21) Anmeldenummer: 11164079.3
(22) Anmeldetag: 28.04.2011
(51) Int. Cl.: F21V 5/04, G02B 3/02, H01L 33/58, H01L 33/54, G02B 3/08, G02B 27/09, F21S 4/00, F21Y 101/02

(54) **LED-Modul mit Linse zum Erzeugen einer nicht rotationssymmetrischen Lichtverteilung**
LED module with lens for generating a non-rotation-symmetric light distribution
Module DEL doté d'une lentille pour produire une diffusion d'éclairage sans rotation symétrique

(30) Priorität: 30.04.2010 DE 102010028416
(43) Veröffentlichungstag der Anmeldung: 02.11.2011
(73) Patentinhaber: Tridonic Jennersdorf GmbH, 8380 Jennersdorf (AT)
(72) Erfinder: Derkits, Christian, 7535, St. Michael (AT)
(74) Vertreter: Rupp, Christian

(56) Entgegenhaltungen:
- EP-A1- 2 085 683
- EP-A1- 2 315 068
- DE-A1-102006 050 880
- DE-A1-102008 006 229
- JP-A- 2004 047 647
- US-A1- 2009 268 469
- US-A1- 2010 073 938

## Beschreibung

Die vorliegende Erfindung betrifft ein LED-Modul mit einer Linse für eine lichtemittierende Diode (LED), insbesondere eine Linse zum Erzeugen einer nicht rotationssymmetrischen Lichtverteilung der LED. Insbesondere ist die nicht rotationssymmetrische Lichtverteilung der LED vorzugsweise annähernd rechteckförmig oder quadratisch.

LEDs zeichnen sich durch eine Vielzahl von Vorteilen als Leuchtmittel aus. Sie können aufgrund ihrer geringen Größe und der parallelen Herstellung in großer Stückzahl durch die moderne Halbleiterprozesstechnik sehr kostengünstig hergestellt werden. Aufgrund ihrer geringen Größe lassen sich LEDs außerdem besonders einfach und platzsparend in Leuchtvorrichtungen integrieren. LEDs weisen zudem einen sehr geringen Stromverbrauch im Vergleich zu herkömmlichen Leuchtmitteln auf und besitzen außerdem eine deutlich höhere Lebenserwartung. Zudem sind sie unempfindlich gegen Erschütterungen und sind schwerer durch äußere Einwirkungen zu beschädigen als herkömmliche Leuchtmittel.

Aufgrund der oben genannten Vorteile werden LEDs heute in einer Vielzahl von Leuchtvorrichtungen eingesetzt. Insbesondere bei zur Darstellung beleuchteter Symbole oder Schriften werden LEDs oft verwendet. Zum Beispiel können eine oder mehrere LEDs dazu Leuchtbuchstaben (bspw. als Ersatz von Leuchtstofflampen) ausleuchten. Herkömmliche LEDs weisen allerdings rotationssymmetrisch ausgestrahltes Licht auf, d.h. rotationssymmetrisch zu einer aus Sichtblickrichtung von oben Mittenachse der LED. Leuchtbuchstaben oder andere Formen weisen Ecken auf, welche durch solche LEDs nur ungleichmäßig ausgeleuchtet werden können, d.h. insbesondere in den Ecken unzureichend. Die Leuchtbuchstaben sind dadurch schlechter zu erkennen, weshalb oft die Leuchtstärke der LEDs erhöht werden muss, um auch in den Ecken eine ausreichende Ausleuchtung zu erzielen. Dadurch allerdings wird mehr Strom verbraucht, und die Kosten zum Betrieb von Leuchtschriften steigen.

Daher ist es wünschenswert, eine nicht rotationssymmetrische Lichtverteilung von LEDs zu erzeugen, um z.B. Leuchtbuchstaben auch in den Ecken der jeweiligen Buchstaben gleichmäßiger auszuleuchten. Die Lichtverteilung sollte dabei möglichst rechteckförmig, bestenfalls quadratisch sein.

Aus dem Stand der Technik ist bereits bekannt, eine im Wesentlichen quadratische Lichtverteilung von LED-Modulen mit eingebauten LEDs durch Reflektoren zu erzeugen, die das Licht in die gewünschte Form umleiten. Bei einem solchen Aufbau von LED-Modulen müssen allerdings zusätzliche Teile, die dann als die Reflektoren dienen, verbaut werden. Der Aufbau des LED-Moduls wird dadurch komplexer und teurer. Außerdem ist es oft schwierig, Reflektoren in sehr kompakten LED-Modulen unterzubringen.

Die EP 2 085 683 A1 offenbart ein lichtemittierendes System mit zumindest einem Leuchtmodul, das zumindest ein Trägersubstrat und eine Mehrzahl von von dem Trägersubstrat gestützten lichtemittierenden Arrays umfasst. Jedes Array umfasst eine Mehrzahl von lichtemittierenden, nichtmodularen Chips. Jedes Array ist von einer lichtreflektierenden Struktur umgeben. Eine Linse ist auf den Arrays vorgesehen, um das von den Array emittierte Licht anzupassen und eine Lichtquelle zu bilden.

Die Aufgabe der vorliegenden Erfindung ist es somit, eine nicht rotationssymmetrische Lichtverteilung einer LED oder eines LED-Moduls zu erzeugen, wobei die Ausführung einfach und kostengünstig realisiert werden soll.

Die Aufgabe wird durch eine Linse für eine LED zum Erzeugen einer nicht rotationssymmetrischen Lichtverteilung der LED gelöst. Die Linse weist eine Lichteinfallseite und eine Lichtausfallseite bezüglich der LED auf. Dabei ist wenigstens die Form der Lichteinfallseite oder auch die Form der Lichtausfallseite nicht rotationssymmetrisch bezüglich der optischen Achse der Linse.

Durch die nicht rotationssymmetrische Form der Lichteinfallseite und gegebenenfalls der Lichtausfallseite wird eine nicht rotationssymmetrische Lichtverteilung der LED erzeugt, da aus bestimmten Teilen der Linse überproportional viel Licht austritt, während aus anderen Teilen der Linse weniger Licht austritt. Durch die erfindungsgemäße Linse kann mit einer oder mehreren LEDs, die Licht durch die Linse ausstrahlen, eine Fläche mit rechteckiger Grundfläche, wie beispielsweise Leuchtbuchstaben, besser und gleichmäßiger ausgeleuchtet werden. In den Ecken der jeweiligen Leuchtbuchstaben ist die Lichtverteilung im Vergleich zu einer Ausleuchtung ohne Linse aufgehellt. Die erfindungsgemäße Linse ist eine einfache und kostengünstige Lösung, da sie aus einem Stück hergestellt werden kann und zum Beispiel direkt in das Gehäuse eines LED-Moduls integriert werden kann. Durch die speziell gestaltete Linse müssen auch keine zusätzlichen Bauteile, wie zum Beispiel Reflektoren oder lichtabschirmende Elemente, verwendet werden, um die gewünschte nicht rotationssymmetrische Lichtverteilung der LED zu erzeugen.

In einem Ausführungsbeispiel ist vorteilhafterweise auch die Form der Lichtausfallseite nicht rotationssymmetrisch.

Durch Wahl dieses Ausführungsbeispiels kann die nicht rotationssymmetrische Lichtverteilung der LED komplex moduliert werden. Die Effekte, den die Lichteinfallseite und die Lichtausfallseite auf die Lichtverteilung der LED ausüben, überlagern sich dabei vorteilhaft.

Erfindungsgemäß wird die Form der wenigstens einen nicht rotationssymmetrischen Seite, also wenigstens der Lichteinfallseite, durch eine nicht rotationssymmetrische Profilierung gebildet.

Die Profilierung ist dabei z.B. eine Vertiefung, eine Aussparung, eine Erhebung oder eine Ausbuchtung, oder eine anderweitig geformte Oberflächentopographie der Lichteinfallseite und gegebenenfalls auch der Lichtausfallseite. Durch die Profilierung der nicht rotationssymmetrischen Seite kann die Linse leicht hergestellt werden, da sie aus einem Stück gebildet werden kann. Es sind keine zusätzlichen Materialkosten notwendig. Ist die Profilierung eine Vertiefung oder Aussparung, so können eine oder mehrere LEDs in dieser Vertiefung oder Aussparung der Linse angeordnet sein. Dadurch wird gewährleistet, dass die LED im Bezug zu der Linse richtig positioniert ist, außerdem ist die Anordnung platzsparend, und die LED wird geschützt.

Erfindungsgemäß ist die Form der nicht rotationssymmetrischen Profilierung ein Polyeder. Insbesondere kann auch eine Pyramide die Form der nicht rotationssymmetrischen Profilierung bilden.

Die Form eines Polyeders, das eine Pyramide, d.h. ein mindestens fünfeckiges Polyeder, sein kann, ist gut dazu geeignet, eine rechteckige Lichtverteilung der LED zu erzeugen. Insbesondere kann auch eine quadratische Lichtverteilung durch z.B. eine Pyramide mit mehreckiger Grundfläche erzeugt werden. Rechteckige bzw. quadratische Flächen können dadurch vorteilhafterweise ausgeleuchtet werden. Die bessere Ausleuchtung wird dadurch ermöglicht, dass überproportional viel Licht zwischen den Kanten durch die aufgrund der pyramidenförmigen Profilierung durch die Linsenform geleitet wird und mehr Licht in z.B. die Ecken von Leuchtbuchstaben gelangt. Die Pyramidenform ist außerdem leicht in die Lichteinfallseite oder die Lichtausfallseite der Linse einzuprägen oder auszufräsen oder die Linse dieser Form entsprechend zu gießen.

Vorteilhafterweise weist das Polyeder eine mehreckige Grundfläche (also ein Polygon) auf, die konvexe und konkave Innenwinkel aufweist. Der Polyeder weist ferner mehrere Kanten auf, die jeweils von einer Spitze des Polyeders bis zu einer der Ecken der mehreckigen Grundfläche verlaufen, wobei zwischen den Kanten des Polyeders jeweils eine Facetten-Fläche entsteht.

Die mehreckige Grundfläche erzeugt ein mehreckiges Polyeder, wie eine Pyramide, mit einer optimierten Eckenausstrahlung. Durch die entstehenden Facetten-Flächen wird Licht überproportional zwischen den Kanten der Pyramide durch die Linsenform geleitet und in eine bestimmte Richtung gebrochen, so dass in diese Richtung eine bessere Ausleuchtung stattfindet. Konvexe Winkel bezeichnen dabei Winkel von weniger als 180°, konkave Winkel bezeichnen Winkel von mehr als 180°.

Vorteilhafterweise zeigen die Normalen der Facettenflächen in etwa in Richtung von Ecken einer auszuleuchtenden Fläche.

Dadurch wird das Licht, das von der LED emittiert wird, vorteilhafterweise so gebrochen, dass überproportional viel Licht durch die Linsenform in Richtung der Ecken der auszuleuchtenden Fläche geleitet wird. Die Ausleuchtung der auszuleuchtenden Fläche wird dabei gleichmäßiger und deutlich besser erkennbar. Durch die gleichmäßigere Ausleuchtung ist auch weniger Leuchtstärke der leuchtenden LEDs notwendig, wodurch die Gesamtkosten gesenkt werden können.

Vorteilhafterweise ist mindestens eine der Facetten-Flächen eine Freiformfläche.

Vorteilhafterweise ist die Grundfläche mindestens viereckig.

Vorteilhafterweise ist die mehreckige Grundfläche achteckig.

Die Grundfläche ist dann also ein Oktagon. Allerdings ist die erfindungsgemäße Linse nicht auf eine spezielle Form beschränkt. Im Prinzip erzeugt eine erfindungsgemäße Linse, die eine polygonale Grundfläche mit mindestens vier Ecken aufweist, d.h. dann ein dreidimensionales Polyhedron bildet, eine mehreckige, d.h. eine nicht rotationssymmetrische, Lichtverteilung. Die Grundfläche kann sogar ein Viereck sein, das gleichmäßig ist, z.B. ein Quadrat, oder ungleichmäßig ist, z.B. ein Trapez. Eine dreieckige Grundfläche, die ein Tetrahedron bildet, funktioniert hingegen nicht.

Vorteilhafterweise weist die mehreckige Grundfläche Begrenzungslinien auf, die vorzugsweise gekrümmt sind.

Vorteilhafterweise sind mindestens drei Innenwinkel der mehreckigen Grundfläche konvex.

Vorteilhafterweise sind die Innenwinkel der mehreckigen Grundfläche alle konvex.

Vorteilhafterweise weist die achteckige Grundfläche vier konvexe und vier konkave Innenwinkel auf.

Dadurch kann die nicht rotationssymmetrische Lichtverteilung die Form eines Vierecks annehmen.

Vorteilhafterweise weist die rotationssymmetrische Seite die Form einer im Wesentlichen konvex geformten Lichtaustrittsfläche auf, die vorzugsweise eine rotationssymmetrische zentrale Vertiefung aufweist.
Die im Wesentlichen konvexe Form ist beispielsweise eine Halbkugel.

Vorteilhafterweise besteht die Linse aus einem Silikon-Abguss.

Dadurch kann die Linse einfach und billig hergestellt werden. Sie besteht aus einem einzelnen homogenen Stück und ist deshalb leicht zu handhaben und weiterzuverarbeiten.

Vorteilhafterweise ist die Linse integrierter Teil eines Oberteils eines Gehäuses eines LED-Moduls, das vorzugsweise im Bereich der Linse oder insgesamt, vorzugsweise einschließlich von Seitenwänden des Oberteils, transparent ist.

Unter LED-Modul ist ein Träger, wie bspw. eine Platine, zu verstehen, auf dem eine oder mehrere LEDs (LED-Chips) angeordnet sind sowie üblicherweise auch wenigstens ein Teil der Ansteuerelektronik für die LED(s).

Dadurch, dass die Linse in das Oberteil eines LED-Modul Gehäuses integriert ist, muss sie nicht zusätzlich an ein LED-Modul angebracht werden. Das Gehäuse des LED-Moduls kann dadurch kleiner konstruiert werden. Das LED-Modul wird dadurch insgesamt kostengünstiger. Das transparente Oberteil des LED-Modul Gehäuses gewährleistet dabei eine gute Lichtausbreitung des emittierten Lichts.

Vorteilhafterweise sind die Linse und das Oberteil des LED-Modul Gehäuses aus einem Silikon-Abguss hergestellt.

Wird die Linse und das LED-Modul Gehäuse aus einem Silikon-Abguss im Gesamten hergestellt, ist nur ein Prozessschritt notwendig, wodurch die Herstellungskosten minimiert werden können.

Vorteilhafterweise weist die Linse Farbstoffpartikel auf, welche entweder in dem Material, aus dem die Linse besteht, enthalten sind oder auf der Linse aufgebracht sind.

Werden solche Farbstoffpartikel verwendet, kann zum Beispiel weißes Licht mit einer nicht rotationssymmetrischen Lichtverteilung erzeugt werden. Die LED strahlt dabei zum Beispiel blaues Licht aus, das auf die Farbstoffpartikel trifft, wodurch Licht einer zweiten Wellenlänge emittiert wird. Die Gesamtemission ist dann für das menschliche Auge als weißes Licht zu erkennen. Allerdings können auch Farbstoffpartikel verwendet werden, die das Farbspektrum, die Farbtemperatur oder die Farbsättigung der LED beeinflussen. Dadurch, dass die Farbstoffpartikel direkt in dem Material der Linse oder auf der Linse sitzen, können diese schon beim Herstellen der Linse oder des LED-Modul Gehäuses mit eingearbeitet werden. Dadurch entfallen weitere Herstellungsschritte.

Die Erfindung betrifft ferner ein LED-Modul, das wenigstens eine LED, die auf einer Leiterplatte angeordnet ist, aufweist. Das LED-Modul weist ferner ein Gehäuse-Oberteil mit einer integrierten Linse auf, die gemäß einem der oben genannten Beispiele gebildet ist. Die Leiterplatine und die LED sind in dem Gehäuse-Oberteil so angeordnet, dass Licht der LED auf die Lichteinfallseite der Linse fällt. Ein Gehäuse-Unterteil, an dem das Gehäuse-Oberteil befestigt wird, ist weiterhin vorgesehen, um die LED und die Leiterplatte in dem Gehäuse einzuschließen.

Das erfindungsgemäße LED-Modul erzeugt eine nicht rotationssymmetrische Lichtverteilung. Das LED-Modul kann kompakt konstruiert werden und kostengünstig hergestellt werden.

Die vorliegende Erfindung betrifft ferner eine Kettenanordnung von LED-Modulen, die wie oben beschrieben konstruiert sind. Die Kettenanordnung kann zur Ausleuchtung größerer nicht rotationssymmetrischer Flächen verwendet werden. Leuchtschriften oder eckige Leuchtsymbole können damit optimal dargestellt werden.

Die vorliegende Erfindung wird nun im Folgenden anhand der beigefügten Figuren im Detail erläutert.
- Fig. 1a-1d: zeigen Ansichten der Linse der vorliegenden Erfindung und eines LED-Moduls, in das die Linse integriert ist.
- Fig. 2a-2d: zeigen Ansichten eines LED-Modul Gehäuse-Oberteils, in das die Linse gemäß der vorliegenden Erfindung integriert ist.
- Fig. 3a: zeigt die Lichtverteilung gemäß dem Stand der Technik, Fig. 3b die Lichtverteilung gemäß der vorliegenden Erfindung.
- Fig. 4: zeigt eine Kettenanordnung von LED-Modulen.

Allgemein bezieht sich die Erfindung auf ein LED-Modul, in dem ein oder mehrere LED-Chips auf einem Träger angeordnet sind. Das LED-Modul ist zusammen mit zumindest einem Teil der Ansteuerelektronik in einem Gehäuse untergebracht.

Die LED kann auch eine OLED sein.

Es können auf dem LED-Modul mehrere LED-Chips angeordnet sein, von denen wenigstens zwei unter einer gemeinsamen Linse angeordnet sind.

Die LEDs können monochromatische und/oder weiße LEDs sein.

Weißlicht kann bei der Erfindung durch RGB-Farbmischung und/oder durch Farbstoff-Konversion erzeugt werden.

Das LED-Modul weist vorzugsweise auch eine Ansteuerelektronik für die LED(s) auf. Die Ansteuerelektronik steuert öder regelt die Stromversorgung der LED(s).

Das LED-Modul wir vorzugsweise extern mit DC-Spannung versorgt. Die DC-Spannungsversorgung kann über flexible Leiter erfolgen, so dass aus mehreren LED-Modulen flexible LED-Beleuchtungsketten gebildet werden können. Diese können bspw. zur Beleuchtung von Leuchtbuchstaben verwendet werden.

Die Spannungsversorgung kann also von einer Stirnseite des Gehäuses zur anderen Stirnseite weitergeschleift sein.

Auf der Oberseite des Gehäuses und oberhalb des/der LED-Chip(s) ist dabei, vorzugsweise unter Bildung eines Luftspalts, wenigstens eine Linse angeordnet.

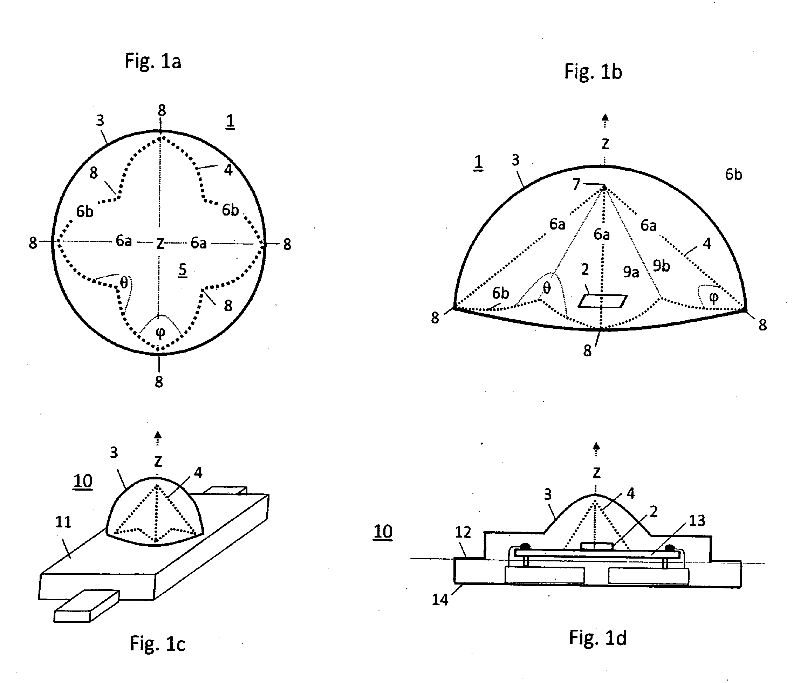

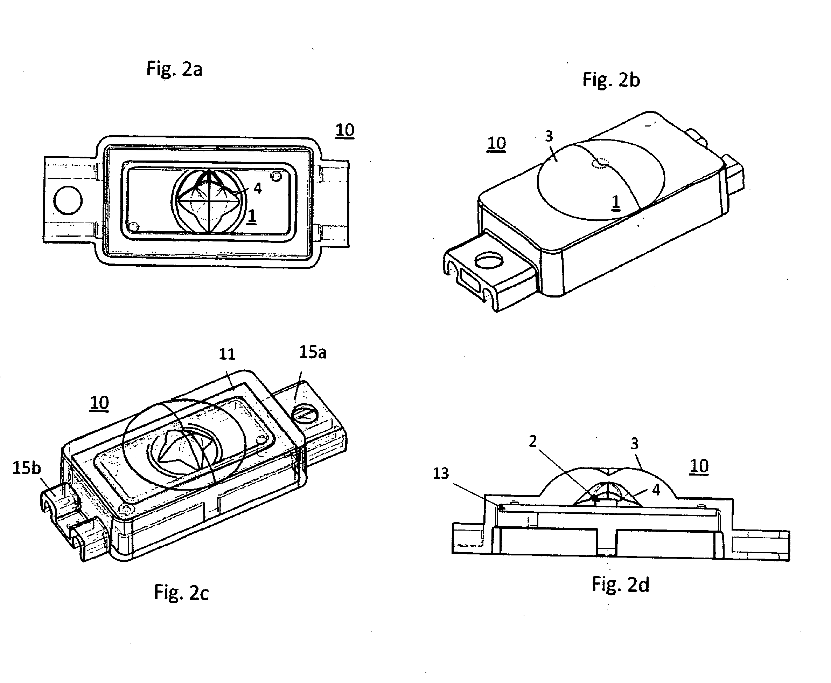

Figuren 1a-1d zeigen nunmehr verschiedene Ansichten einer solchen erfindungsgemäßen Linse 1. Figur 1a ist dabei eine Draufsicht der Linse 1. Die Lichteinfallseite der Linse 1 ist als gestrichelte Linie dargestellt, die Lichtausfallseite der Linse 1 als durchgezogene Linie. In dem gezeigten Beispiel ist die Lichteinfallseite nicht rotationssymmetrisch bezüglich der optischen Achse z der Linse 1. Die Lichtausfallseite ist dagegen rotationssymmetrisch bezüglich der optischen Achse z der Linse 1. Zusätzlich kann allerdings auch die Lichtausfallseite nicht rotationssymmetrisch sein. Figur 1b. zeigt eine Seitenansicht der Linse 1 mit der nicht rotationssymmetrischen Lichteinfallseite und der rotationssymmetrischen Lichtausfallseite. Die Blickrichtung auf Figur 1a ist entlang der optischen Achse z, während die Blickrichtung in Figur 1b von der Seite senkrecht auf die optische Achse z gerichtet ist. Bei der Linse 1, die in Figur 2a und 2b gezeigt ist, hat die rotationssymmetrische Lichtausfallseite eine im Wesentlichen konvexe Form, hier die Form einer Halbkugel 3. Die nicht rotationssymmetrische Lichteinfallseite hat die Form eines Polyeders 4, z.B. eines fünfeckigen Polyeders wie einer Pyramide. Allerdings kann auch die Lichtausfallseite nicht rotationssymmetrisch sein.

Die Form des Polyeders 4, hier einer Pyramide, wird hierbei durch eine Profilierung der Lichteinfallseite gebildet. Genauer gesagt kann die Profilierung z.B. eine Aussparung oder eine Vertiefung sein, die in die rotationssymmetrische Halbkugel 3 auf der Lichteinfallseite hergestellt worden ist. Innerhalb dieser Aussparung oder Vertiefung kann, wie in Fig. 1b gezeigt, eine LED 2 positioniert sein. Das von der LED 2 ausgestrahlte Licht wird maßgeblich durch die Linse 1 beeinflusst. Durch die nicht rotationssymmetrische pyramidenförmige Profilierung ist die gesamte Lichtverteilung von LED 2 und Linse 1 ebenso nicht rotationssymmetrisch. Dadurch können eckige, nicht rotationssymmetrische Flächen gleichmäßiger ausgeleuchtet werden. Beispielsweise können Leuchtschriften deutlicher dargestellt werden und trotz geringer Strahlkraft der LED 2 ausreichend ausgeleuchtet werden. Da die Linse 1, die aus der Lichteinfallseite und der Lichtausfallseite besteht, durch die oben genannte Profilierung aus einem einzelnen Materialstück hergestellt werden kann, ist die Herstellung der Linse 1 sehr kostengünstig. Durch das Anbringen der LED 2 innerhalb der Profilierung der Linse 1 ist die LED 2 optimal positioniert, um Licht auf die Linse 1 zu strahlen, wodurch die Lichtverteilung des Systems aus Linse 1 und LED 2 exakt modelliert werden kann.

Eine Möglichkeit, die nicht rotationssymmetrische Lichteinfallseite zu bilden, ist eine Profilierung in Form einer mehrzackigen Pyramide 4. Selbstverständlich kann die Profilierung auch andere nicht rotationssymmetrische Formen annehmen. Jedes Polyhedron mit mehr als vier Kanten ist dazu geeignet. Grundflächen 5 sind Polygone, insbesondere können auch Oktagone gute Ergebnisse erzielen Da allerdings meistens rechteckige oder quadratische Flächen ausgeleuchtet werden müssen, ist eine Pyramide mit acht Ecken 8, wie unten beschrieben, vorteilhaft. Die Pyramide 4 kann allerdings auch weniger oder mehr als acht Ecken 8 aufweisen.

Eine bevorzugte Form der Pyramide 4 ist in den Figuren 1a und 1b dargestellt. Diese Form ist insbesondere dazu geeignet, eine annähernd quadratische Lichtverteilung der LED 2 zu erzeugen. Die Pyramide 4 weist, wie in Figur 1a dargestellt, eine Grundfläche 5 mit acht Ecken 8 auf. Die Ecken 8 werden dabei von vier konvexen ϕ und vier konkaven θ Innenwinkeln gebildet. Vier Ecken von konkaven θ Innenwinkeln und vier Ecken 8 von konvexen ϕ Innenwinkeln.. Dabei können die konvexen Innenwinkel ϕ für alle Ecken 8 gleich sein oder unterschiedlich sein. Um eine quadratische Lichtverteilung zu erzielen, ist es vorteilhaft, alle konvexen Innenwinkel ϕ gleich zu bemessen. Konvexe Innenwinkel sind Winkel kleiner als 180°, konkave Innenwinkel sind Winkel größer als 180°.

Wie in Figur 1b gezeigt, laufen von jeder Ecke 8 der Pyramide 4 Kanten 6a zur Spitze 7 der Pyramide 4, die eine Ecke des fünfeckigen Polyeders (Pyramide) ist, die nicht zur Grundfläche gehört. Die Höhe der Pyramide 4, d.h. die Position der Spitze 7 der Pyramide 4, ist dabei durch die rotationssymmetrische Halbkugel 3, die in dieser Ausführungsform die Lichtausfallseite bildet, begrenzt. Vorteilhafterweise, wie später beschrieben, weist die rotationssymmetrische Halbkugel 3 noch eine zentrale Vertiefung auf, wodurch die Höhe der Pyramide 4 etwas geringer wird.

Das von der LED 2 ausgestrahlte Licht wird überproportional zwischen den Ecken 8 der Pyramide 4 durch die Linse 1 geleitet und weniger an den Ecken 8 der Pyramide 4 durch die Linse 1 geleitet. Dadurch wird die Lichtverteilung nicht rotationssymmetrisch und nimmt idealerweise eine rechteckige oder quadratische Form an. Um diesen Effekt vorteilhafterweise zu verstärken, ist die Grundfläche 5 der Pyramide 4, wie in der Figur 1a dargestellt, vorzugsweise mehreckig oder sternförmig. Zwischen den Ecken 8 verlaufen jeweils Begrenzungslinien 6b der Grundfläche 5, die vorzugsweise, wie dargestellt, gekrümmt sind. Die Krümmung kann konvex oder konkav sein. Die Begrenzungslinien können aber auch gerade, d.h. nicht gekrümmt, verlaufen. Durch die mehreckige Grundfläche 5 und die Spitze 7 wird eine mehreckige, sternförmige Pyramide 4, wie gut in Figur 1b aus der Seitenansicht zu erkennen, gebildet. Zwischen den Kanten 6a der Pyramide 4, die von den Ecken 8 bis zur Pyramidenspitze 7 laufen, bildet sich jeweils eine Facetten-Fläche 9a bzw. 9b aus. Die Facetten-Flächen 9a und 9b stehen daher in Winkeln aufeinander, die den konkaven θ bzw. den konvexen ϕ Innenwinkeln der mehreckigen Grundfläche 5 entsprechen. Die Innenwinkel der mehreckigen Grundfläche 5 können dabei entweder alle konvex sein, alle gleich sein oder beliebige sein und nicht in Bezug zueinander stehen. In dem gezeigten Ausführungsbeispiel gibt es vier konvexe ϕ und vier konkave θ Innenwinkel, wobei im Umlauf um die Grundfläche 5 jeweils ein konkaver Innenwinkel θ auf einen konvexen Innenwinkel ϕ folgt.

Die Innenwinkel ϕ, θ können vorteilhafterweise so gewählt werden, dass die Normalen der dadurch entstehenden FacettenFlächen 9a und 9b annähernd in die Richtung von Ecken auszuleuchtender Flächen zeigen. Durch die Facetten-Flächen 9a und 9b wird überproportional viel des von der LED 2 ausgestrahlten Lichts geleitet und so gebrochen, dass es in die auszuleuchtenden Ecken gestrahlt wird. Mehr Licht wird auch an der Schnittlinie der Facettenflächen 9a und 9b, an denen konkave Innenwinkel θ gebildet sind, als an den übrigen Ecken 8, an denen konvexe Innenwinkel ϕ gebildet sind, ausgeleitet. An den Kanten 6a, welche die Ecken 8 und die Pyramidenspitze 7 verbinden, wird weniger Licht durch die Linse 1 geleitet als durch die Facetten-Flächen 9a, 9b. Dadurch entsteht eine nicht-rotationssymmetrische Lichtverteilung. Betrachtet man die mehreckige Grundfläche 5 in Figur 1a, so tritt die größte Beleuchtungsstärke der LED 2 in einem Winkel von etwa 45°, d.h. in etwa dort, wo die Facetten-Flächen 9a, 9b in konkaven Innenwinkeln aufeinander stehen, aus. Hingegen ist die Beleuchtungsintensität im Winkel von 90°, d.h. an den Ecken 8 der konvexen Innenwinkel ϕ verringert.

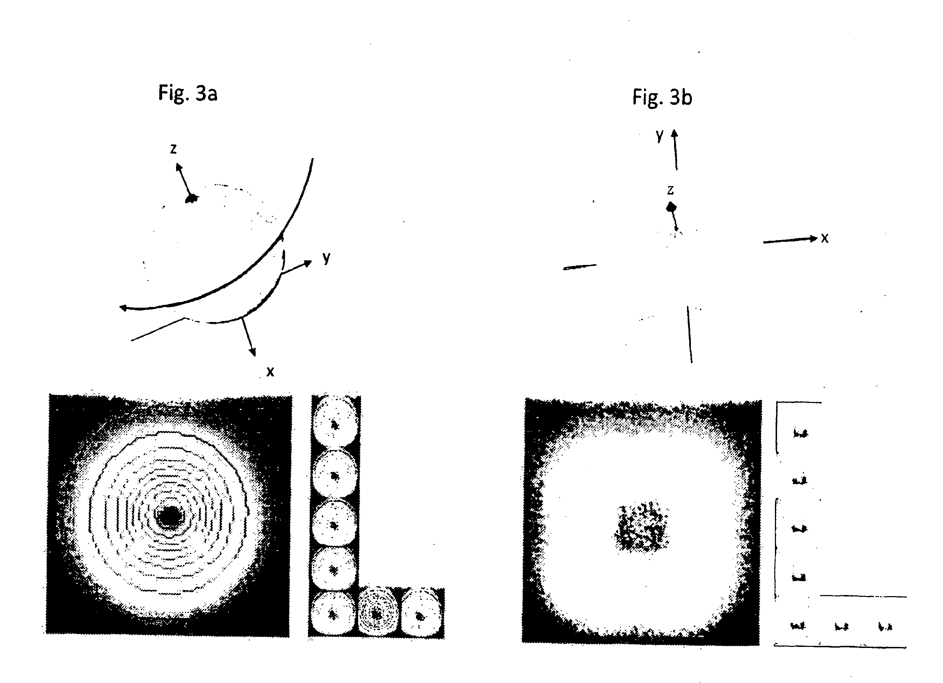

Werden alle konkaven Innenwinkel θ und alle konvexen Innenwinkel ϕ der Pyramide 4 gleich gewählt, und besitzt die Pyramide 4 vier Ecken 8, so erreicht man eine annähernd quadratische Lichtverteilung. Eine solche annähernd quadratische Lichtverteilung ist in der Figur 3b dargestellt. Dabei ist im oberen Teil der Figur 3b eine dreidimensionale Lichtverteilung gezeigt, die kissenförmig ist, was einer Quadratform nahe kommt. Die Achse z ist dabei die optische Achse z der Linse 1. Die Lichtverteilung ist nicht rotationssymmetrisch bezüglich der optischen Achse z. Im unteren Teil der Figur 3b ist die Lichtverteilung in x- und y-Richtung dargestellt, die Lichtverteilung in z-Richtung ist als Schwarz-Weiß-Kodierung angedeutet. Dabei ist deutlich zu erkennen, dass die Lichtverteilung annähernd quadratisch ist und deshalb gut geeignet ist, z.B. Leuchtbuchstaben auszuleuchten. Im Gegensatz dazu ist in Figur 3a eine rotationssymmetrische Lichtverteilung einer herkömmlichen LED 2 ohne erfindungsgemäße Linse 1 gezeigt. Die Lichtverteilung nimmt in drei Dimensionen die Form einer Kugel an (oberer Teil) und weist folglich in Bezug auf ihre x- und y-Ausdehnung eine Kreisform auf (unterer Teil). Als verdeutlichendes Beispiel ist mit den jeweiligen Lichtverteilungen andeutungsweise ein Leuchtbuchstabe L ausgeleuchtet. Dabei ist deutlich zu erkennen, dass aufgrund der nicht rotationssymmetrischen, annähernd quadratischen Lichtverteilung in Figur 3b der Leuchtbuchstabe L gleichmäßiger ausgeleuchtet werden kann. Hingegen ist in Figur 3a zu erkennen, dass die rotationssymmetrische Lichtverteilung die Ecken des Leuchtbuchstabens L weniger stark ausleuchtet als die zentralen Abschnitte. Dadurch muss eine ungleichmäßigere Wahrnehmung des Leuchtbuchstabens L in Kauf genommen werden.

Die Linse 1, die aus einer Lichteinfallseite und einer Lichtausfallseite besteht, welche in den Figuren 1a und 1b als rotationssymmetrische Halbkugel 3 bzw. nicht-rotationssymmetrische Profilierung in Form einer Pyramide 4 mit mehreckiger, sternförmiger Grundfläche 5 realisiert sind, kann aus einem einzigen Abguss, vorzugsweise einem Silikon-Abguss bestehen. Dadurch kann die Linse 1 aus einem homogenen Stück und damit sehr kostengünstig hergestellt werden. Es ist auch möglich, die erfindungsgemäße Linse 1 in einem Oberteil 12 eines LED-Modulgehäuses 11 eines LED-Moduls 10 zu integrieren. Zum Beispiel ist in den Figuren 1c und 1d gezeigt, wie die Linse 1 aus den Figuren 1a und 1b weiter in einem Gehäuse 11 eines LED-Moduls 10 eingebaut ist. In Figur 1d ist dabei eine Seitenansicht des LED-Moduls 10 gezeigt. Das LED-Modul 10 besitzt dabei ein Gehäuse 11, das aus einem Oberteil 12 und einem Unterteil 14 zusammengesetzt ist, wobei das Gehäuse-Oberteil 12 und das Gehäuse-Unterteil 14 aneinander befestigt sind. Die Befestigung kann z.B. durch eine Klebung oder durch eine Verschraubung realisiert werden.

Das Gehäuse-Oberteil 12 ist dabei mit der Linse 1 integriert. Vorteilhafterweise werden dabei das Gehäuse-Oberteil 12 und die Linse 1 direkt aus einem Stück gefertigt, vorzugsweise durch einen Silikon-Abguss hergestellt. Die rotationssymmetrische Halbkugel 3 schließt dabei direkt an die Oberfläche des Gehäuse-Oberteils 12 an und steht daraus als eine Erhebung vor. Die Halbkugel 3 ist auf der Lichteinfallseite mit einer Pyramide 4 profiliert. Diese bildet eine Vertiefung oder Aussparung, in der eine LED 2 positioniert wird. Die LED 2 ist zusätzlich auf einer Leiterplatte 13 angeordnet, über welche sie elektrisch kontaktiert und gestützt wird.

Die LED 2 kann dabei jede Art handelsüblicher LEDs oder OLED sein. Die LED 2 kann auch eine farbstoffkonvertierte LED 2 sein. Des Weiteren kann die LED 2 mit einer Treiberschaltung versehen sein und wird durch eine Spannungsversorgung betrieben. Die Spannungsversorgung kann dabei Wechselspannung, Gleichspannung oder eine Notspannung sein.

Wenn die LED 2 betrieben wird, strahlt sie Licht aus, welches auf die Lichteinfallseite der Linse 1, die als Pyramide 4 profiliert ist, fällt. Das Licht wird durch die an der Lichtausfallseite der Linse 1, die als Halbkugel 3 geformt ist, ausgegeben. Die Lichtverteilung des LED-Moduls 10 ist dann nicht rotationssymmetrisch, wie oben beschrieben. Innerhalb des LED-Moduls 10 können insbesondere in dem Gehäuse-Unterteil 14 weitere Schaltungen, Blöcke oder Zuleitungen eingebaut sein, die zum Beispiel für den Betrieb der LED 2 verwendet werden. Zum Beispiel kann eine Steuerschaltung eingebaut sein, welche die LED steuert. Oder es können einer oder mehrere Sensoren eingebaut sein, die mit der Steuerschaltung verbunden sind, um diese zu veranlassen, die LED 2 nur bei bestimmten detektierten Verhältnissen, wie einer gewissen äußeren Lichtstärke, äußeren Temperatur oder ähnlichem, einzuschalten und/oder auszuschalten. Denkbar ist auch, die Steuerschaltung so auszulegen, dass sie die Leuchtstärke der LED 2 regeln kann, unter Umständen entsprechend Ausgangssignalen der Sensoren.

Figur 1c zeigt eine perspektivische Ansicht des LED-Moduls 10. Das Gehäuse des LED-Moduls 10 ist darin zu sehen sowie die Linse 1 mit der Lichtausfallseite als Halbkugel 3 und der Lichteinfallseite als Aussparung in Form einer Pyramide 4. Die Linse 1 kann dabei auch Farbstoffpartikel aufweisen oder enthalten, die entweder in das Material, aus dem die Linse 1 besteht, direkt eingebracht sind oder innerhalb oder außerhalb der Linse aufgebracht sind. Wird die Linse 1 aus einem Silikon-Abguss hergestellt, so können z.B. die Farbstoffpartikel mit eingegossen werden. Die Farbstoffpartikel können dazu verwendet werden das Farbspektrum der LED 2, oder die Farbtemperatur bei weißen LEDs oder die Farbsättigung der LED 2 zu verändern. Es kann z.B. eine blau leuchtende LED 2 verwendet werden und durch einen geeigneten Farbstoff weißes Licht erzeugt werden. Dabei regt das blaue Licht der LED 2 den Farbstoff an, der Licht einer weiteren Wellenlänge emittiert, wodurch dem Betrachter insgesamt ein weißes Farbspektrum erscheint.

Das gesamte LED-Modulgehäuse 11 ist vorzugsweise transparent. Dadurch wird eine gute Lichtausbreitung des Lichts, das von der LED 2 ausgesandt wird, gewährleistet. In den Figuren 2a bis 2d sind weitere Darstellungen von LED-Modulen 10 abgebildet, deren Gehäuse 11 mit einer Linse 1 gemäß der vorliegenden Erfindung versehen ist. Figur 2a ist dabei eine Draufsicht entlang der optischen Achse z der Linse 1. Figur 2d ist eine Seitenansicht, und Figur 2b und Figur 2c sind perspektivische Ansichten des LED-Moduls 10. In Figur 2c ist dabei das Gehäuse 11 des LED-Moduls 10 transparent, so dass auch die Lichteinfallseite der Linse 1 als mehreckige Pyramide 4 zu erkennen ist. In Figur 2b ist auch die rotationssymmetrische Lichtausfallseite als Halbkugel 3 zu erkennen. Diese weist dabei zentral um die optische Achse z in der Mitte der Halbkugel 3 eine Vertiefung auf. Die Vertiefung ist in Figur 2b rotationssymmetrisch in Form einer kreisförmigen Mulde angedeutet. Die Vertiefung kann allerdings auch nicht rotationssymmetrisch sein. Die Vertiefung unterstützt die vorteilhafte Lichtverteilung der Linse 1.

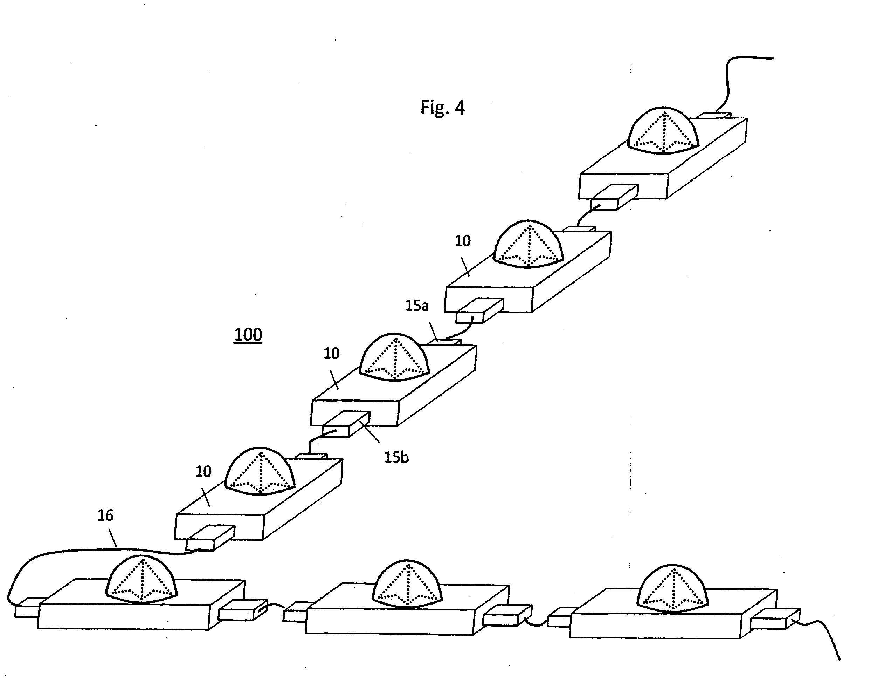

Zur Ausleuchtung von Symbolen oder Schriften, wie z.B. Leuchtbuchstaben, können vorteilhafterweise mehrere LED-Module 10 in der Kettenanordnung 100 aneinander gereiht werden. Eine solche erfindungsgemäße Kettenanordnung 100 ist in Figur 4 dargestellt. Diese leuchtet beispielweise Leuchtbuchstaben in L-Form, wie auch schon in den Figuren 3a und 3b angedeutet, aus. Wie z.B. gut in den Figuren 3b und 3c zu erkennen ist, besitzen die Gehäuse 11 der LED-Module 10 auf beiden ihrer Längsseiten Vorsprünge 15a bzw. 15b. Diese sind dazu ausgelegt, Stromleitungen 16 in das Innere der LED-Module 10 zu leiten und diese daran zu befestigen.

Die Stromleitungen 16 versorgen die LEDs 2 in den LED-Modulen 10 mit Spannung bzw. Strom. An den Vorsprüngen 15a und 15b können die Stromleitungen 16 befestigt werden, damit sie bei Zug nicht von den Anschlüssen im Inneren des Gehäuses 11 abreißen. So können z.B. mit einer einzigen durchgängigen Stromleitung, wie in Fig. 4 dargestellt, mehrere LED-Module 10 zu einer Kettenanordnung 100 aneinandergereiht werden. Zum Betrieb der mehreren LED-Module 10 ist demnach nur eine Spannungsversorgung notwendig, die Strom in Serie durch alle LED-Module 10 fließen lässt. Wird die Stromleitung 16 als herkömmliches, flexibles Kabel realisiert, so sind die LED-Module 10 gegeneinander beweglich und können leicht zum Beispiel für die Ausleuchtung verschiedener Leuchtbuchstaben verändert werden. In Fig. 4 ist gezeigt, wie zum Beispiel ein L realisiert wird. Durch einfaches Neuanordnen der LED-Module 10 kann dann eine andere Form gewählt werden.

Alternativ können die Stromleitungen zwischen den LED-Modulen 10 auch starr gefertigt werden, so dass eine festgelegte Form ausgeleuchtet wird. Der Vorteil ist dabei die erhöhte Stabilität der Kettenanordnung 100. Jedes einzelne LED-Modul 10 in der Kettenanordnung 100 weist dabei eine nicht rotationssymmetrische, vorzugsweise annähernd rechteckförmige, Lichtverteilung auf.

Vorteilhafterweise sind in den Gehäusen 11 der LED-Module 10 bzw. in den integrierten Linsen 1 noch Streupartikel vorhanden. Diese können entweder bei der Herstellung durch einen Silikon-Abguss mit eingegossen werden, ähnlich wie die Farbstoffpartikel, die oben beschrieben wurden, oder können nachträglich aufgebracht werden. Die Streupartikel bewirken eine Verschmierung der Lichtverteilung, so dass zum Beispiel bei einer Kettenanordnung 100 aus Fig. 4 nicht helle Punkte an den Positionen der LEDs 2 entstehen sondern die Lichtverteilung gleichmäßiger über die komplette Form der Kettenanordnung 100 verteilt wird.

Zusammenfassend beschreibt die vorliegende Erfindung eine Linse 1, zum Erzeugen einer nicht rotationssymmetrischen Lichtverteilung einer LED 2. Die Linse 1 kann dabei in ein LED-Modul 10 integriert sein, mehrere LED-Module 10 wiederum können zu einer Kettenanordnung 100 zusammengeschlossen werden. Die Linse 1 weist dabei eine Lichteinfallseite und eine Lichtausfallseite auf, wobei wenigstens die Form der Lichteinfallseite nicht rotationssymmetrisch bezüglich der optischen Achse z der Linse 1 ist.

In einem bevorzugten Ausführungsbeispiel wird die Linse 1 mit einer rotationssymmetrischen Halbkugel 3 als Lichtausfallseite und einer nicht rotationssymmetrischen Profilierung in Form eines Polyeders, wie einer Pyramide 4, auf der Lichteinfallseite gebildet. Die Pyramide 4 ist dabei idealerweise mit einer mehreckigen Grundfläche 5 versehen, so dass Facetten-Flächen 9a und 9b entstehen, durch die überproportional viel Licht aus der Linse 1 geleitet wird. Durch die ungleichmäßige Ausleitung des Lichts entsteht in Blickrichtung auf die Linse 1 entlang der optischen Achse z eine nicht rotationssymmetrische, vorzugsweise rechteckige oder sogar quadratische, Lichtverteilung. Dies ermöglicht es, rechteckige Flächen, wie zum Beispiel Leuchtbuchstaben, gleichmäßiger auszuleuchten. Weitere Vorteile der Linse 1 sind die kostengünstige und einfache Herstellung bzw. die einfache Integration in ein Gehäuse 11 eines LED-Moduls 10.

## Patentansprüche

1. Linse (1) für ein LED-Modul mit einer oder mehreren LED, zum Erzeugen einer nicht rotationssymmetrischen Lichtverteilung der LED (2), aufweisend:
eine Lichteinfallseite und eine Lichtausfallseite bezüglich der LED (2);
wobei wenigstens die Form der Lichteinfallseite bezüglich der optischen Achse (z) der Linse (1) nicht rotationssymmetrisch ist, **dadurch gekennzeichnet, dass** wenigstens die Form der nicht rotationssymmetrischen Lichteinfallseite durch eine nicht rotationssymmetrische Profilierung gebildet wird, die vorzugsweise eine Aussparung oder Vertiefung ist, und
wobei die nicht rotationssymmetrische Profilierung ein Polyeder (4), der mindestens fünf Ecken aufweist, ist.

2. Linse (1) gemäß Anspruch 1, wobei ferner die Form der Lichtausfallseite nicht rotationssymmetrisch ist.

3. Linse (1) gemäß Anspruch 1, wobei
die Lichtausfallseite rotationssymmetrisch ist und die Form einer im Wesentlichen konvex geformten Lichtaustrittsfläche aufweist, die vorzugsweise eine rotationssymmetrische zentrale Vertiefung (9) aufweist.

4. Linse (1), gemäß einem der Ansprüche 1 bis 3, wobei der Polyeder (4) eine mehreckige Grundfläche (5) aufweist, die mehrere konvexe (ϕ) und konkave (θ) Innenwinkel aufweist, und mehrere Kanten (6a), die jeweils von einer Spitze (7) des Polyeders (4) bis zu einer der Ecken (8) der mehreckigen Grundfläche (5) verlaufen, wobei zwischen den Kanten (6a) des Polyeders (4) jeweils eine Facetten-Fläche (9a, 9b) entsteht.

5. Linse (1) gemäß Anspruch 4, wobei die Normalen der Facetten-Flächen (9a, 9b) in etwa Richtung von Ecken einer auszuleuchtenden Fläche zeigen.

6. Linse (1) gemäß Anspruch 4 oder 5, wobei mindestens eine der Facetten-Flächen (9a, 9b) eine Freiformfläche ist.

7. Linse (1), gemäß Anspruch 4 oder 5, wobei die mehreckige Grundfläche (5) mindestens viereckig ist.

8. Linse (1), gemäß Anspruch 4 oder 5, wobei die mehreckige Grundfläche (5) achteckig ist.

9. Linse (1), gemäß einem der Ansprüche 4 bis 8, wobei die mehreckige Grundfläche (5) Begrenzungslinien (6b) aufweist, die vorzugsweise gekrümmt sind.

10. Linse (1), gemäß einem der Ansprüche 4 bis 8, wobei mindestens drei Innenwinkel (ϕ, θ) der mehreckigen Grundfläche (5) konvex sind.

11. Linse (1), gemäß einem der Ansprüche 4 bis 9, wobei die Innenwinkel (ϕ, θ) der mehreckigen Grundfläche (5) alle konvex sind.

12. Linse (1), gemäß Anspruch 8, wobei die achteckige Grundfläche (5) vier konvexe (ϕ) und vier konkave (θ) Innenwinkel aufweist.

13. Linse (1), gemäß einem der Ansprüche 1 bis 12, die aus einem Silikon-Abguss besteht.

14. Linse (1), gemäß einem der Ansprüche 1 bis 13, die Teil eines Oberteils (12) eines LED-Modul-Gehäuses (11) ist, das vorzugsweise transparent ist.

15. Linse, gemäß Anspruch 14, wobei die Linse und das Oberteil (12) des LED-Modul-Gehäuses (11) aus einem Silikon-Abguss hergestellt sind.

16. Linse (1), gemäß einem der Ansprüche 1 bis 15, die Farbstoffpartikel aufweist, welche entweder in dem Material aus dem die Linse (1) besteht enthalten sind, oder auf der Linse (1) aufgebracht sind.

17. LED-Modul (10), das aufweist:
wenigstens eine LED (2), die auf einer Leiterplatte (13) angeordnet ist;
ein Gehäuse-Oberteil (12) mit einer integrierten Linse (1), die gemäß einem der Ansprüche 1 bis 16 gebildet ist, wobei die Leiterplatte (13) und die LED (2) in dem Gehäuse-Oberteil (12) so angeordnet sind, dass Licht der LED (2) auf die Lichteinfallseite (4) der Linse (1) fällt; und
ein Gehäuse-Unterteil (14), an dem das Gehäuse-Oberteil (12) befestigt ist, um die LED (2) und die Leiterplatte (13) in der Linse (1) einzuschließen.

18. LED-Modul nach Anspruch 17, das eine oder mehrere LED-Chips aufweist, die durch Farbmischung und/oder Farbkonversion Weißlicht erzeugen.

19. Kettenanordnung (100) von mehreren flexibel miteinander verbundenen LED-Modulen (10) gemäß Anspruch 17 oder 18 zur Ausleuchtung nicht rotationssymmetrischer Flächen

## Claims

1. Lens (1) for an LED module with one or several LEDs for generating a non-rotation-symmetric light distribution of the LED (2), having:
a light incidence side and a light emergence side respective the LED (2);
wherein at least the form of the light incidence side respective the optical axis (z) of the lens (1) is non-rotation-symmetric, **characterized in that** at least the form of the non-rotation-symmetric light incidence side is formed by a non-rotation-symmetric profiling that is preferably a notch or recess, and wherein the non-rotation-symmetric profiling is a polyhedron (4) that has at least five corners.

2. Lens (1) according to claim 1, wherein furthermore the form of the light emergence side is non-rotation-symmetric.

3. Lens (1) according to claim 1, wherein the light emergence side is rotation-symmetric and has the form of an essentially convex-shaped light exit area that preferably has a rotation-symmetric central recess (9).

4. Lens (1) according to one of the claims 1 to 3, wherein the polyhedron (4) has a polygonal base (5) that has several convex (ϕ) and concave (θ) interior angles, and several edges (6a) running, respectively, from a tip (7) of the polyhedron (4) up to one of the corners (8) of the polygonal base (5), wherein one facet surface (9a, 9b), respectively, forms between the edges (6a) of the polyhedron (4).

5. Lens (1) according to claim 4, wherein the normal of the facet surfaces (9a, 9b) point approximately towards corners of an area to be illuminated.

6. Lens (1) according to claim 4 or 5, wherein at least one of the facet surfaces (9a, 9b) is a free-form surface.

7. Lens (1) according to claim 4 or 5, wherein the polygonal base (5) is at least quadrangular.

8. Lens (1) according to claim 4 or 5, wherein the polygonal base (5) is octagonal.

9. Lens (1) according to one of the claims 4 to 8, wherein the polygonal base (5) has boundary lines (6b) that are preferably curved.

10. Lens (1) according to one of the claims 4 to 8, wherein at least three interior angles (ϕ, θ) of the polygonal base (5) are convex.

11. Lens (1) according to one of the claims 4 to 9, wherein the interior angles (ϕ, θ) of the polygonal base (5) are all convex.

12. Lens (1) according to claim 8, wherein the octagonal base (5) has four convex (ϕ) and four concave (θ) interior angles.

13. Lens (1) according to one of the claims 1 to 12, consisting of a silicone casting.

14. Lens (1) according to one of the claims 1 to 13, that is part of an upper part (12) of an LED module housing (11) that is preferably transparent.

15. Lens (1) according to claim 14, wherein the lens and the upper part (12) of the LED module housing (11) are made of a silicone casting.

16. Lens (1) according to one of the claims 1 to 15, that has dye particles, which are either included in the material the lens (1) is made out of or applied to the lens (1).

17. LED module (10), having:
at least one LED (2), arranged on a circuit board (13);
a housing upper part (12) with an integrated lens (1), formed according to one of the claims 1 to 16, wherein the circuit board (13) and the LED (2) are arranged in the housing upper part (12) in such a way that light from the LED (2) falls onto the light incidence side (4) of the lens (1); and
a housing lower part (14), onto which the housing upper part (12) is attached in order to enclose the LED (2) and the circuit board (13) in the lens (1).

18. LED module according to claim 17 having one or several LED chips that generate white light by means of color mixing and/or color conversion.

19. Chain arrangement (100) of several flexible inter-connected LED modules (10) according to claim 17 or 18 for illuminating non-rotation-symmetric surfaces.

## Revendications

1. Lentille (1) destinée à un module DEL comportant une ou plusieurs DEL pour produire une diffusion d'éclairage sans rotation symétrique de la DEL (2), ayant :
un côté d'incidence de lumière et un côté d'émergence de lumière correspondant à la DEL (2) ;
dans laquelle au moins la forme du côté d'incidence de lumière correspondant à l'axe optique (z) de la lentille (1) est sans rotation symétrique, **caractérisée en ce qu'**au moins la forme du côté d'incidence de lumière sans rotation symétrique est formée par un profilage sans rotation symétrique étant de préférence une encoche ou un renfoncement, et dans laquelle le profilage sans rotation symétrique est un polyèdre (4) ayant au moins cinq sommets.

2. Lentille (1) selon la revendication 1, dans laquelle de plus la forme du côté d'émergence de lumière est sans rotation symétrique.

3. Lentille (1) selon la revendication 1, dans laquelle le côté d'émergence de lumière est à rotation symétrique et a la forme d'une zone de sortie de lumière essentiellement de forme convexe qui, de préférence, possède un renfoncement central (9) à rotation symétrique.

4. Lentille (1) selon l'une des revendications de 1 à 3, dans laquelle le polyèdre (4) possède une base polygonale (5) possédant plusieurs angles intérieurs convexes (ϕ) et concaves (θ) et plusieurs arêtes (6a) partant, respectivement, d'un sommet (7) du polyèdre (4) jusqu'à un des sommets (8) de la base polygonale (5), dans laquelle une surface à facettes (9a, 9b) se forme, respectivement, entre les arêtes (6a) du polyèdre (4).

5. Lentille (1) selon la revendication 4, dans laquelle la normale des surfaces à facettes (9a, 9b) pointe approximativement vers les coins d'une zone à éclairer.

6. Lentille (1) selon les revendications 4 ou 5, dans laquelle au moins une des surfaces à facettes (9a, 9b) est une surface à géométrie quelconque.

7. Lentille (1) selon les revendications 4 ou 5, dans laquelle la base polygonale (5) est au moins quadrangulaire.

8. Lentille (1) selon les revendications 4 ou 5, dans laquelle la base polygonale (5) est octogonale.

9. Lentille (1) selon l'une des revendications de 4 à 8, dans laquelle la base polygonale (5) possède des lignes de délimitation (6b) étant de préférence incurvées.

10. Lentille (1) selon l'une des revendications de 4 à 8, dans laquelle au moins trois angles intérieurs (ϕ, θ) de la base polygonale (5) sont convexes.

11. Lentille (1) selon l'une des revendications de 4 à 9, dans laquelle les angles intérieurs (ϕ, θ) de la base polygonale (5) sont tous convexes.

12. Lentille (1) selon la revendication 8, dans laquelle la base octogonale (5) possède quatre angles intérieurs convexes (ϕ) et quatre angles intérieurs concaves (θ).

13. Lentille (1) selon l'une des revendications de 1 à 12, consistant en une pièce moulée en silicone.

14. Lentille (1) selon l'une des revendications de 1 à 13, faisant partie d'une partie supérieure (12) d'un logement (11) de module DEL étant de préférence transparent.

15. Lentille (1) selon la revendication 14, dans laquelle la lentille et la partie supérieure (12) du logement de module DEL (11) sont constituées d'une pièce moulée en silicone.

16. Lentille (1) selon l'une des revendications de 1 à 15, ayant des particules colorées étant soit incluses dans le matériau dont la lentille (1) se compose ou appliquées sur la lentille (1).

17. Module DEL (10), ayant :
au moins une DEL (2), disposée sur une carte de circuit imprimé (13) ;
une partie de logement supérieure (12) dotée d'une lentille intégrée (1), réalisée selon l'une des revendications de 1 à 16, dans lequel la carte de circuit imprimé (13) et la DEL (2) sont disposés dans la partie de logement supérieure (12) de manière à ce que la lumière provenant de la DEL (2) frappe le côté d'incidence de lumière (4) de la lentille (1) ; et
une partie de logement inférieure (14), sur laquelle la partie de logement supérieure (12) est fixée afin de renfermer la DEL (2) et la carte de circuit imprimé (13) dans la lentille (1).

18. Module DEL selon la revendication 17, ayant une ou plusieurs puces DEL produisant une lumière blanche par le biais d'un mélange de couleurs et/ou d'une conversion de couleurs.

19. Disposition de chaîne (100) de plusieurs modules DEL (10) souples interconnectés selon les revendications 17 ou 18 destinés à éclairer des surfaces sans rotation symétrique.
